Europäisches Patentamt

European Patent Office

Office européen des brevets

(11) Numéro de publication : **0 412 024 B1**

(12) **FASCICULE DE BREVET EUROPEEN**

(45) Date de publication du fascicule du brevet :
**08.06.94 Bulletin 94/23**

(51) Int. Cl.$^5$ : **G01R 19/02, G01R 19/04**

(21) Numéro de dépôt : **90420334.6**

(22) Date de dépôt : **12.07.90**

(54) **Dispositif de mesure de la valeur efficace d'un signal, notamment pour la mesure du courant dans un déclencheur statique.**

(30) Priorité : **31.07.89 FR 8910398**

(43) Date de publication de la demande :
**06.02.91 Bulletin 91/06**

(45) Mention de la délivrance du brevet :
**08.06.94 Bulletin 94/23**

(84) Etats contractants désignés :
**BE CH DE ES GB IT LI SE**

(56) Documents cités :
**DE-A- 2 914 389
GB-A- 860 681
GB-A- 2 036 984
FUNKSCHAU. no. 19, septembre 1983, MUN-
CHEN DE pages 79 - 82; Hörmannsdorfer:"Genauigkeit ist keine Hexerei"**

(73) Titulaire : **MERLIN GERIN
2, chemin des Sources
F-38240 Meylan (FR)**

(72) Inventeur : **Fraisse, Didier
Merlin Gerin,
Sce. Brevets
F-38050 Grenoble Cedex (FR)**

(74) Mandataire : **Jouvray, Marie-Andrée et al
MERLIN GERIN
Sce. Propriété Industrielle
F-38050 Grenoble Cédex 9 (FR)**

## Description

DISPOSITIF DE MESURE DE LA VALEUR EFFICACE D'UN SIGNAL, NOTAMMENT POUR LA MESURE DU COURANT DANS UN DECLENCHEUR STATIQUE.

L'invention concerne un dispositif de mesure de la valeur efficace d'un signal, notamment pour la mesure du courant dans un déclencheur statique comportant un circuit redresseur double alternance à l'entrée duquel est appliqué le signal à mesurer et dont le signal de sortie, redressé, est appliqué à l'entrée d'un filtre passe-bas du premier ordre.

Dans les déclencheurs statiques actuels deux méthodes sont essentiellement utilisées pour mesurer la valeur efficace d'un signal représentatif d'un courant.

Selon la première méthode, utilisée essentiellement dans les déclencheurs de type analogique, on détermine la valeur crête d'un signal et cette valeur est multiplié par 0,707. Cette méthode, si elle donne des résultats satisfaisants lorsque le signal d'entrée est un signal sinusoïdal pur, conduit à des erreurs très importantes dès que le signal d'entrée est perturbé.

Selon la seconde méthode, utilisée dans les déclencheurs à microprocesseur, le signal d'entrée est échantillonné et la valeur efficace calculée en faisant la somme des carrés d'un certain nombre d'échantillons. Cette seconde méthode, si elle fournit des résultats plus précis, est relativement complexe à mettre en oeuvre et en conséquence chère.

Des dispositifs de mesure, comportant un circuit de redressement et un filtre RC, comme celui décrit dans le document DE-A-2.914.389, ne permettent pas une mesure précise de valeurs efficaces si les signaux à mesurer ne sont pas de forme purement sinusoïdale ou continue.

L'invention a pour but un dispositif simple et bon marché permettant de déterminer la valeur efficace d'un signal avec une précision suffisante même dans le cas d'un signal perturbé.

Plus particulièrement, l'invention doit permettre de mesurer un signal présentant un facteur de crête inférieur à 2,5 avec une précision supérieure à 20 %.

Selon l'invention ce but est atteint par un dispositif dans lequel, le signal de sortie du filtre est appliqué à l'entrée d'un détecteur de crête dont la tension de sortie est représentative de la valeur efficace du signal d'entrée, la pulsation de coupure du filtre étant déterminée de manière à être comprise entre 4 $\pi$f/6 et 4 $\pi$f/5,33, f étant la fréquence fondamentale du signal d'entrée destiné à être appliqué au dispositif.

Selon un mode de réalisation préférentiel le filtre est un filtre de type RC.

Lorsque le signal destiné à être appliqué à l'entrée du dipositif est un signal de fréquence fondamentale 50 Hz, le filtre est dimensionné de manière à avoir une constante de temps comprise entre 8,5 et 9,5 ms, et de préférence égale à 9 ms.

D'autres avantages et caractéristiques ressortiront plus clairement de la description qui va suivre de modes de mise en oeuvre de l'invention, donnés à titre d'exemples non limitatifs et illustrés par les dessins dans lesquels :

Les figures 1 et 2 illustrent un dispositif selon l'invention dans le cas où le signal d'entrée est constitué respectivement par une tension et par un courant.

La figure 3 représente plus en détail un mode de réalisation préférentiel du dispositif selon la figure 2.

Les figures 4 et 5 illustrent les formes d'onde des signaux en divers points du dispositif lorsque le signal d'entrée est sinusoïdal.

La figure 6 représente en fonction de la fréquence, l'amplitude relative des diverses composantes d'un signal sinusoïdal redressé dont la fréquence est de 50 Hz.

Les figures 7 et 8 illustrent les résultats obtenus avec un dispositif selon l'invention lorsque des harmoniques de rangs impairs et d'amplitude variable sont superposés à un signal sinusoïdal d'entrée.

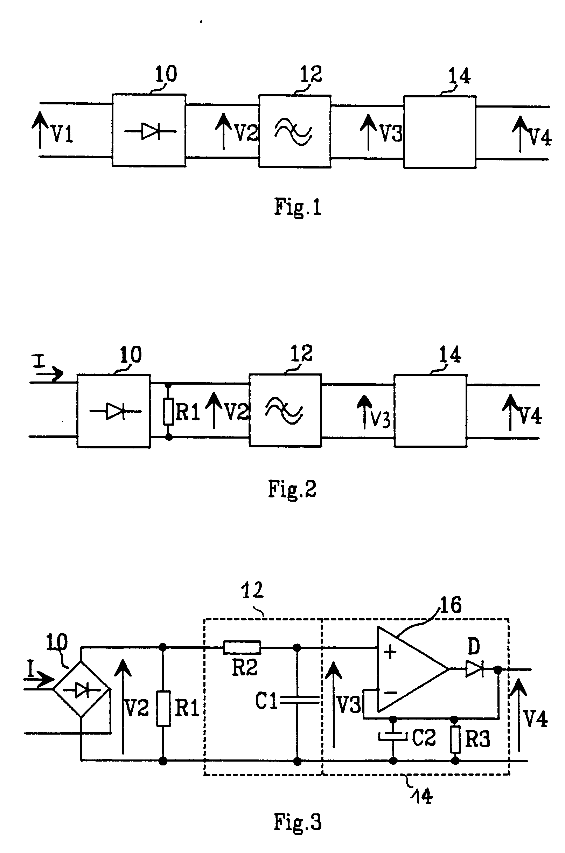

Sur la figure 1, le signal d'entrée V1, dont on veut mesurer la valeur efficace, est appliqué à l'entrée d'un circuit redresseur double alternance 10. La tension V2 de sortie du circuit redresseur est appliquée à l'entrée d'un filtre passe-bas du premier ordre 12. La tension V3 de sortie du filtre est appliquée à l'entrée d'un détecteur de crête 14 dont la tension de sortie V4 est représentative de la valeur efficace du signal d'entré V1.

Le circuit selon la figure 2 diffère de celui selon la figure 1 par le fait que le signal d'entrée est constitué par un courant I et non par une tension V1. Une résistance de mesure R1 est disposée en parallèle sur la sortie du circuit redresseur 10. Le signal V2 de sortie du redresseur, qui est comme précédemment un signal redressé représentatif du signal d'entrée, est traité de la même manière que dans le circuit selon la figure 1.

Dans le mode de réalisation préférentiel représenté sur la figure 3, le filtre 12 est constitué par un filtre RC comportant une résistance R2 disposée entre une première entrée et une première sortie du filtre et un condensateur C1 connecté entre des première et seconde sorties du filtre, les secondes entrée et sortie du filtre étant connectées directement l'un à l'autre. La constante de temps d'un tel filtre passe-bas est donné par T=R2C1.

Le détecteur de crête 14 peut être constitué de toute manière connue. La figure 3 illustre un mode particulier, connu de réalisation. Sur cette figure, le détecteur est constitué par un amplificateur opérationnel 16, dont la borne d'entrée non-inverseuse est connectée à la première sortie du filtre 12. Sa borne inverseuse est connectée directement à une première sortie du détecteur et, par l'intermédiaire d'un condensateur C2, en parallèle sur une résistance R3, à une seconde entrée du détecteur, elle-même reliée à une seconde sortie de celui-ci. La sortie de l'amplificateur opérationnel est connectée à l'anode d'une diode D dont la cathode est reliée à la première sortie du détecteur. La tension V4 présente entre les première et seconde sorties du détecteur de crête 14 est représentative de la valeur de crête du signal de tension V3 appliqué entre les entrées du détecteur.

Le fonctionnement du dispositif selon l'invention va être explicité ci-dessous.

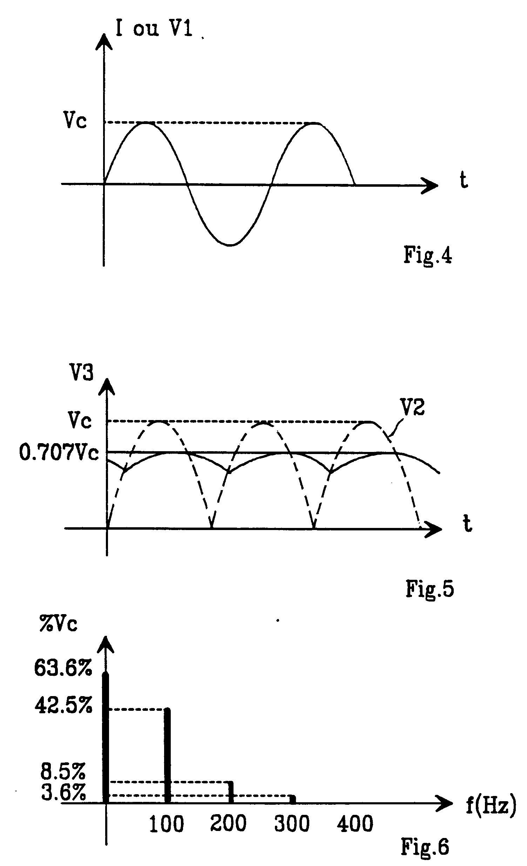

Supposons que le signal d'entrée soit un signal sinusoïdal pur de fréquence 50 Hz, dont la valeur crête est représentée par Vc sur la figure 4. Le signal V2, redressé, représenté en pointillé sur la figure 5, a la même valeur crête Vc.

Après filtrage par le filtre 12, le signal V3 (fig.5) a une valeur crête égale à la valeur efficace Veff=0,707Vc du signal d'entrée. Cette valeur crête est alors détectée par le détecteur de crête 14 dont le signal V4 de sortie est représentatif de la valeur efficace du signal d'entrée V1.

La constante de temps de filtrage T=R2C1 du filtre 12, déterminée expérimentalement pour un signal d'entrée I ou V1 dont la fréquence fondamentale est 50 Hz, est de 9 ms.

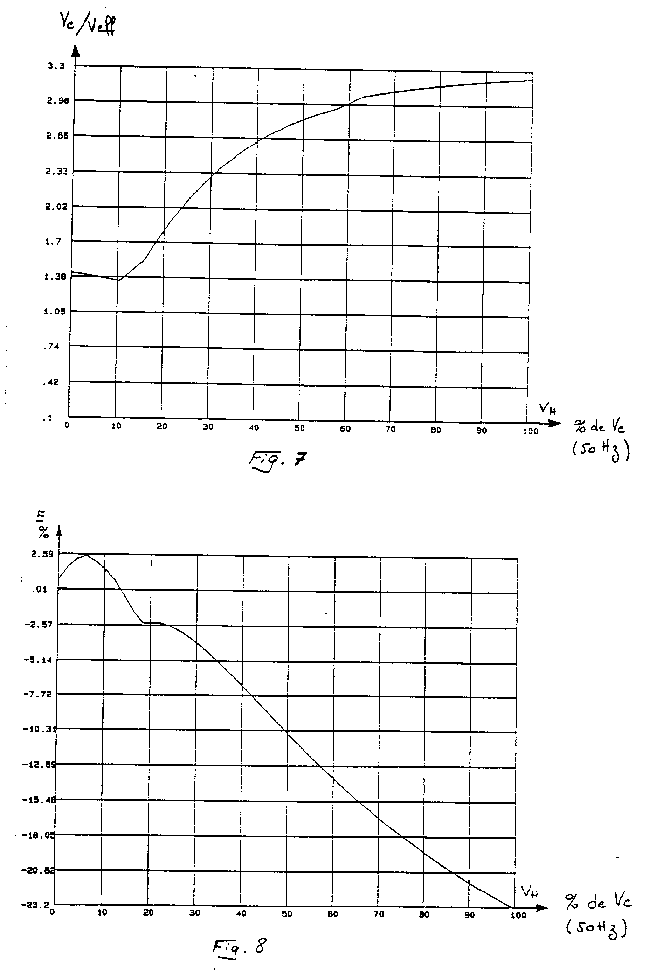

Les figures 7 et 8 montrent les résultats expérimentaux obtenus avec un filtre ayant une constante de temps de 9 ms lorsque 20 harmoniques de rangs impairs et de même amplitude sont superposés à un signal sinusoïdal d'entrée dont la fréquence fondamentale est de 50 Hz.

Sur la figure 7 le facteur de crête, Vc/Veff est représenté en fonction du rapport en pourcentage, entre l'amplitude (ou valeur crête) VH des harmoniques et l'amplitude (ou valeur crête) Vc (50 Hz) du signal de fréquence fondamentale.

La figure 8 représente en pourcentage, en fonction du même rapport d'amplitudes, l'erreur E commise en assimilant la valeur crête du signal de sortie du filtre (V4) à la tension efficace réelle Veff du signal d'entrée (fondamental et harmoniques), obtenue par calcul, soit E=100x(V4-Veff)/Veff.

Il ressort clairement de ces figures que pour un facteur de crête inférieur à 2,5, l'erreur commise est inférieure à 4,5 %.

Des mesures réalisées avec des signaux d'entrée comportant divers types d'harmoniques, ont permis de vérifier que l'erreur réalisée en assimilant la valeur de sortie V4 du dispositif selon l'invention à la valeur efficace est toujours inférieure à 10 % dans la pratique. Cette erreur est, de plus, généralement très inférieure à celle obtenue en assimilant la valeur efficace à 0,707 fois la valeur crête du signal d'entrée.

A titre d'exemples les valeurs suivantes ont été relevées :

| Veff | Vc | Facteur de crête Vc/Veff | V4 | Erreur filtre | Erreur crête | |
|---|---|---|---|---|---|---|
| 0,49 | 1,12 | 2,29 | 0,462 | − 5,6 % | + 62 % | |
| 0,616 | 1,158 | 1,88 | 0,582 | − 5,4 % | + 33 % | |
| 0,496 | 1,144 | 2,30 | 0,452 | − 8,73 % | + 63 % | |
| 5,693 | 7,33 | 1,28 | 5,24 | − 7,86 % | − 9 % | |
| 0,636 | 1 | 1,57 | 0,583 | − 8,38 % | + 11,2 % | |
| 0,745 | 1,334 | 1,79 | 0,697 | − 6,4 % | + 27 % | |

avec une erreur filtre E=100 (V4-Veff)/Veff et une erreur crête donnée par 100 (0,707 Vc - Veff)/Veff.

L'invention n'est pas limitée à la mesure de la valeur efficace d'un signal d'entrée dont la fréquence fondamentale est 50 Hz.

Les formules ci-dessous permettent de calculer, une valeur approchée de la constante du temps de filtrage en fonction de la fréquence fondamentale du signal d'entrée.

En effet, pour un signal d'entrée sinusoïdal, le signal redressé V2 peut être décomposé en une série du type :

V2=Vc (0,636+0,425 cos 2ωt-0,085cos4ωt + 0,036cos6ωt - 0,02 cos8ωt...) dans laquelle ω = 2πf est la pulsation correspcondant à la fréquence du signal sinusoïdal d'entrée du redresseur.

Comme représenté sur la figure 6, le signal V2 se décompose alors en un signal continu dont l'amplitude correspond à 63,6 % de la valeur crête du signal d'entrée, soit la valeur moyenne du signal d'entrée, une première raie correspondant à l'harmonique 2 (100 Hz) de la fréquence fondamentale (50 Hz) du signal d'entrée et dont l'amplitude correspond à 42,5 % de la valeur crête du signal d'entrée, une seconde raie correspondant à l'harmonique 4 (200 Hz) et dont l'amplitude, en valeur absolue, est égale à 8,5 % de la valeur crête, l'amplitude des raies suivantes allant en décroissant.

La valeur efficace du signal d'entrée Veff=0,707 Vc est égale à la valeur efficace du signal redressé et le carré de la valeur efficace est égal à la somme des carrés des valeurs efficaces des diverses composantes du signal.

Ainsi, la valeur efficace de la composante continue du signal V2, est donnée par 0,636 Vc. L'erreur est alors de (0,636 - 0,707) Vc/0,707 Vc =-0,1, soit-10 % par rapport à la valeur efficace réelle du signal d'entrée.

On peut montrer que la valeur efficace d'un signal composé par la composante continue et la première raie (harmonique 2) est 0,703 Vc, soit une erreur de - 0,56 %.

Pour un signal composé de la composante continue et des deux premières raies (harmoniques 2 et 4), la valeur efficace est 0,706 Vc soit une erreur de - 1 ‰.

Si l'on affecte à chacune des composantes un gain représentant le rapport entre sa contribution à la valeur efficace et l'amplitude de la composante, on obtient les valeurs suivantes :

```
Raie      : Amplitude: Contribution à la : Gain              :
          : (xVc)    : valeur efficace   :                   :
          :          :    (xVc)          :                   :
---------------------------------------------------------------:
Continue: 0,636      :    0,636          :   1               :
          :          :                   :                   :
1e raie : 0,425      :0,703-0,636 = 0,067:0,067/0,425 =0,158:
          :          :                   :                   :
2e raie : 0,085      :0,706-0,703 = 0,003:0,003/0,085 =0,035:
```

On peut donc obtenir la valeur efficace du signal d'entrée en affectant à chacune des composantes du signal redressé un gain approprié et en faisant la somme des signaux ainsi obtenus. Or, le gain qui est unitaire à fréquence nulle, diminue très rapidement lorsque la fréquence de la composante augmente.

Selon une première approximation, le résultat recherché est obtenu au moyen d'un filtre passe-bas du premier ordre. Un tel filtre a une fonction de transfert, fonction de la fréquence (pulsation ω1), du type F=1/(1+ω1/ωc), dans laquelle ωc est la pulsation de coupure du filtre. Pour la première raie, soit lorsque ω1 = 2ω = 2π x2f = 4 π f, f étant la fréquence fondamentale (par exemple 50 Hz) du signal d'entrée, la fonction de transfert du filtre doit être égale à 0,158 :

$$0,158 = 1/(1 + 4 \pi f/\omega c)$$

soit 1 + 4 π f/ωc = 1/0,158 = 6,33

ωc = 4 π f /5,33 et T = 5,33/4 π f.

Si l'on considère la seconde raie (harmonique de rang 4), la fonction de transfert est alors

$$F = 1/(1 + 10,66) = 0,085.$$

On s'aperçoit que cette fonction de transfert est trop importante par rapport au gain qui devrait être affecté à cette raie, soit 0,035, et conduit, si l'on considère la composante continue et les deux premières raies, à une valeur mesurée de 0,710 Vc, correspondant à une erreur de + 0,42 %.

De même, cette valeur de la fréquence de coupure conduit à une fonction de transfert de 0,059 pour la 3e raie (harmonique 6) soit une contribution à la valeur mesurée de 0,059x0,036Vc=0,002Vc, augmentant encore l'erreur.

Avec cette première approximation, la contribution de la composante continue et de la 1e raie correspondant à 0,703Vc, la contribution des 2e, 3e, et 4e raies est de 0,01Vc, d'où une erreur de + 0,85 % dans le cas d'un signal sinusoïdal pur.

Pour réduire cette erreur si la contribution de la le raie, qui reste prépondérante, est réduite en conséquence, cette contribution est alors de (0,707-0,636-0,01) · Vc=0,061Vc, correspondant à une fonction de transfert F=0,061/0,425=0,143 pour la 1e raie, soit un rapport 4 $\pi$ f/$\omega$c =6 et T =6/4$\pi$ f.

Bien entendu, avec l'augmentation de ce rapport 4$\pi$ f/$\omega$c , la contribution des autres raies est également réduite, à 0,0065Vc pour la 2e raie, 0,0019Vc pour la 3e raie et 0,0008 Vc pour la 4e raie, d'où une valeur V4 correspondant à 0,706Vc, soit - 1‰ d'erreur.

Pour que l'erreur soit minimale dans le cas d'un signal d'entrée sinusoïdal sans harmoniques, la contribution de la 1e raie ne doit pas être réduite au-delà de cette valeur. La précision finalement obtenue est fonction de la perturbation du signal mesuré.

Pour un signal sinusoïdal d'entrée de 50 Hz, la fréquence de coupure du filtre correspondrait avec la première approximation à une pulsation.

$\omega$c= 4$\pi$ x50/5,33=117 Hz soit une constante de temps de filtrage T = 1/$\omega$c = 8,5 ms et, après correction maximale à une pulsation :$\omega$c= 4$\pi$x50/6, soit une constante de temps de filtrage de 9,5 ms.

Ces valeurs sont bien conformes à la valeur (9 ms) déterminée expérimentalement, qui tient compte du fait que l'erreur doit être inférieure à 2,5, quelle que soit la forme du signal d'entrée, c'est-à-dire quels que soit le nombre et l'amplitude des harmoniques superposés au signal fondamental.

La constante de temps de filtrage étant ainsi déterminée il est facile de choisir des valeurs appropriées pour la résistance R2 et le condensateur C1 du filtre 12, tels que T=R2C1.

Le dispositif décrit ci-dessus donne également une valeur représentative de la valeur efficace dans le cas où le signal d'entrée est un signal continu, ou un signal rectangulaire. En effet, dans ce cas le signal redressé est un signal continu et le signal de sortie du filtre a la même amplitude que le signal d'entrée, cette amplitude étant représentative de la valeur efficace du signal d'entrée.

Bien que l'invention ait été décrite avec un filtre du type RC, il est clair qu'elle peut être mise en oeuvre à l'aide de tout filtre ayant une fréquence de coupure adaptée, notamment à l'aide de filtres numériques ou de filtres à capacités commutées.

Dans les déclencheurs statiques le signal à mesurer, fourni par l'enroulement secondaire d'un transformateur de courant, est un signal de fréquence fondamentale 50 Hz ou 60 Hz. Le dispositif décrit ci-dessus permet, avec des moyens très simples, d'obtenir une valeur représentative de la valeur efficace du signal à mesurer pouvant être utilisée, de manière connue, par le déclencheur pour fournir à un disjoncteur un signal de déclenchement lorsque la valeur efficace mesurée dépasse un certain seuil.

## Revendications

1. Dispositif de mesure de la valeur efficace d'un signal, notamment pour la mesure du courant dans un déclencheur statique, comportant un circuit redresseur double alternance (10) à l'entrée duquel est appliqué le signal (I, V1) à mesurer et dont le signal de sortie, redressé (V2), est appliqué à l'entrée d'un filtre passe-bas du premier ordre (12), dispositif caractérisé en ce que le signal (V3) de sortie du filtre est appliqué à l'entrée d'un détecteur de crête (14) dont la tension de sortie (V4) est représentative de la valeur efficace du signal d'entrée (I, V1), la pulsation ($\omega_c$) de coupure du filtre étant déterminée de manière à être comprise entre 4 $\pi$f/6 et 4$\pi$f/5,33, f étant la fréquence fondamentale du signal d'entrée destinée à être appliqué au dispositif.

2. Dispositif selon la revendication 1, caractérisé en ce que le signal d'entrée étant un courant (I), une résistance (R1) est disposée en parallèle sur la sortie du circuit redresseur (10).

3. Dispositif selon l'une des revendications 1 et 2, caractérisé en ce que le filtre (12) est un filtre RC, dont les composants (R2,C1) sont dimensionnés de manière à ce que la constante de temps (T) du filtre soit comprise entre 5,33/4$\pi$f et 6/4$\pi$f.

4. Dispositif selon la revendication 3, caractérisé en ce que le signal (I,V1) d' entrée du dispositif ayant une fréquence fondamentale de 50 Hz, la constante de temps (T) du filtre (12) est comprise entre 8,5 et 9,5 ms.

5. Dispositif selon la revendication 4, caractérisé en ce que la constante de temps (T) du filtre est égale à 9 ms.

## Claims

1. A device for measuring the rms value of a signal, notably for current measurement in a solid-state trip device, comprising a full-wave rectifier circuit (10) to whose input the signal (I, V1) to be measured is applied and whose rectified output signal (V2) is applied to the input of a first order low-pass filter (12), a device characterized in that the output signal (V3) from the filter is applied to the input of a peak detector (14) whose output voltage (V4) is representative of the rms value of the input signal (I, V1), the filter cut-off pulse ($\omega c$) being determined in such a way as to be comprised between $4\Pi f/6$ and $4\Pi f/5.33$, f being the fundamental frequency of the input signal designed to be applied to the device.

2. The device according to claim 1, characterized in that the input signal being a current (I), a resistor (R1) is connected in parallel to the output of the rectifier circuit (10).

3. The device according to one of the claims 1 and 2, characterized in that the filter (12) is an RC filter, whose components (R2, C1) are dimensioned in such a way that the time constant (T) of the filter is comprised between $5.33/4\Pi f$ and $6/4\Pi f$.

4. The device according to claim 3, characterized in that the input signal (I, V1) of the device having a fundamental frequency of 50 Hz, the time constant (T) of the filter (12) is comprised between 8.5 and 9.5 ms.

5. The device according to claim 4, characterized in that the time constant (T) of the filter is equal to 9 ms.

## Patentansprüche

1. Schaltungsanordnung zur Messung des Effektivwerts eines Signals, insbesondere zur Messung des Stroms in einem elektronischen Auslöser, mit einer Doppelweg-Gleichrichterschaltung (10), an deren Eingang das zu messende Signal (I, V1) angelegt wird und deren gleichgerichtetes Ausgangssignal (V2) dem Eingang eines Tiefpaßfilters erster Ordnung (12) zugeführt wird, dadurch gekennzeichnet, daß das Ausgangssignal (V3) des Filters dem Eingang eines Scheitelwertmessers (14) zugeführt wird, dessen Ausgangsspannung (V4) den Effektivwert des Eingangssignals (I, V1) abbildet, wobei die Grenzfrequenz (wc) des Filters so gewählt ist, daß sie zwischen die $4\P f/6$ und $4\P f/5,33$ liegt, wobei f die Grundfrequenz des Eingangssignal ist, mit dem die Meßanordnung beaufschlagt werden soll.

2. Schaltungsanordnung nach Anspruch 1, dadurch gekennzeichnet, daß das Eingangssignal einen Strom (I) darstellt und ein Widerstand (R1) parallel an den Ausgang der Gleichrichterschaltung (10) geschaltet ist.

3. Schaltungsanordnung nach Anspruch 1 oder 2, dadurch gekennzeichnet, daß das Filter (12) als RC-Filter ausgeführt ist, dessen Schaltungskomponenten (R2, C1) so dimensioniert sind, daß die Zeitkonstante (T) des Filters zwischen $5,33/4\P f$ und $6/4\P f/$ liegt.

4. Schaltungsanordnung nach Anspruch 3, dadurch gekennzeichnet, daß das Eingangssignal nach (I, V1) der Schaltungsanordnung eine Grundfrequenz von 50 Hz aufweist und die Zeitkonstante (T) des Filters (12) zwischen 8,5 und 9,5 ms liegt.

5. Schaltungsanordnung nach Anspruch 4, dadurch gekennzeichnet, daß die Zeitkonstante (T) des Filters 9 ms beträgt.

Fig.1

Fig.2

Fig.3

I ou V1

Vc

t

Fig.4

V3

Vc

0.707Vc

V2

t

Fig.5

%Vc

63.6%

42.5%

8.5%
3.6%

100    200    300    400    f(Hz)

Fig.6

Fig. 7

Fig. 8